# EUROPEAN PATENT APPLICATION

(11) **EP 4 832 671 A2**
(43) Date of publication of application: **28.10.2026**
(21) Application number: 26162556.0
(22) Date of filing: 05.03.2026
(51) Int. Cl.: H05K 1/03, H05K 1/02, H05K 3/24, H05K 1/11

(54) **COMPONENT CARRIER AND METHOD OF MANUFACTURING THE SAME**

(30) Priority: 31.03.2025 CN 202510396701
(71) Applicant: AT & S Austria Technologie & Systemtechnik Aktiengesellschaft, 8700 Leoben (AT)
(72) Inventor: BAFTIRI, Artan, 8010 Graz (AT); REN, Raab, Chongqing, 401133 (CN)
(74) Representative: Donatello, Daniele

(57) **Abstract**

A component carrier (100) which comprises a stack (102) which comprises at least one electrically conductive layer structure (104) and a plurality of electrically insulating layer structures (106, 108), at least part of said at least one electrically conductive layer structure (104) being provided on and/or in a main surface (110) of one of said plurality of electrically insulating layer structures (106, 108), and a surface finish layer (118) at least partially covering an exposed surface of said at least one electrically conductive layer structure (104), wherein the main surface (110) of the one of said plurality of electrically insulating layer structures (106, 108) is configured to inhibit attraction and attachment of metal ions and/or metal particles on said main surface (110). The present application further provides a method of manufacturing a component carrier (100).

## Description

The invention relates to a component carrier, and to a method of manufacturing a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

It is an object of the invention to provide a reliable component carrier.

In order to achieve the object defined above, a component carrier and a method of manufacturing a component carrier according to the independent claims are provided.

According to an exemplary embodiment, a component carrier is provided which comprises a stack which comprises at least one electrically conductive layer structure and a plurality of electrically insulating layer structures, at least part of said at least one electrically conductive layer structure being provided on and/or in a main surface of one of said plurality of electrically insulating layer structures, and a surface finish layer at least partially covering an exposed surface of said at least one electrically conductive layer structure, wherein the main surface of the one of said plurality of electrically insulating layer structures is configured to inhibit attraction and attachment of metal ions and/or metal particles on said main surface.

According to another exemplary embodiment of the invention, a method of manufacturing a component carrier is provided, wherein the method comprises providing a stack which comprises at least one electrically conductive layer structure and a plurality of electrically insulating layer structures, at least part of said at least one electrically conductive layer structure being provided on and/or in a main surface of one of said plurality of electrically insulating layer structures, at least partially covering an exposed surface of said at least one electrically conductive layer structure by a surface finish layer, and configuring the main surface of the one of said plurality of electrically insulating layer structures to inhibit attraction and attachment of metal ions and/or metal particles on said main surface.

In the context of the present application, the term "component carrier" may particularly denote any support structure which is capable of accommodating one or more components thereon and/or therein for providing mechanical support and/or electrical connectivity and/or thermal conductivity. In other words, a component carrier may be configured as a mechanical and/or electronic and/or thermal carrier for components. In particular, a component carrier may be one of a printed circuit board, an organic interposer, and an IC (integrated circuit) substrate. For example, a component carrier may be a rigid-flex carrier, or a flexible substrate. A component carrier may also be a hybrid board combining different ones of the above-mentioned types of component carriers. In particular, a component carrier may comprise a stack comprising a plurality of electrically conductive layer structures and/or electrically insulating layer structures.

In the context of the present application, the term "stack" may particularly denote a flat or planar sheet-like body. For instance, the stack may be a layer stack, in particular a laminated layer stack or a laminate. Such a laminate may be formed by connecting a plurality of layer structures, which preferably may be arranged in a parallel manner, by the application of mechanical pressure and/or heat.

In the context of the present application, the term "layer structure" may particularly denote a continuous layer, a patterned layer or a plurality of nonconsecutive islands within a common plane.

In the context of the present application, the term "surface finish layer" may particularly denote a layer, for instance a thin film, of material selectively applied to an exposed surface of an electrically conductive layer structure of the component carrier. The surface finish may protect the underlying metal (in particular copper) against oxidation and/or may raise the wettability of a contact areas, for instance for soldering. Such a surface finish may be an electrically conductive cover material on one or more exposed electrically conductive layer structures (such as pads, conductive tracks, etc., in particular comprising or consisting of copper) at a surface of a component carrier. If such exposed electrically conductive layer structures are left unprotected, then the exposed electrically conductive component carrier material (in particular copper) might oxidize, making the component carrier less reliable. A surface finish may be formed for instance as an interface between a surface mounted component and the component carrier. The surface finish has the function to protect the exposed electrically conductive layer structure(s) (in particular copper circuitry) and enable a joining process, for example with one or more components, for instance by soldering. Examples for appropriate materials for a surface finish are Electroless Nickel Electroless Palladium Immersion Gold (ENEPIG), Electroless Nickel Immersion Gold (ENIG), Electroless Nickel Immersion Palladium Immersion Gold (ENIPIG), gold (in particular hard gold), chemical tin, nickel-gold, nickel-palladium, etc.

In the context of the present application, the term "inhibit attraction and attachment of metal ions and/or metal particles" may particularly denote a property of an exposed electrically insulating layer structure being functionalized or configured so that metallic residues are actively prevented from accumulating at a main surface of the electrically insulating layer structure. The inhibition may be partially or entirely in a sense that either the amount of metallic residues are reduced compared with a scenario without the functionalization or configuration, or that any metallic residue is eliminated from the main surface of the electrically insulating layer structure. Hence, the inhibition of attraction and attachment of metal ions and/or metal particles may be a suppression or even an elimination of metallic residues on the main surface. This inhibition or hindering may be accomplished for example by a material selection and/or by an adjustment of a surface topography or morphology of the electrically insulating layer structure and its main surface. For example, said metal ions and/or metal particles may be any metallic particles, electrically charged metal ions, and/or metal composition. For instance, they may be in the form of residues on an exposed electrically insulating layer structure and/or ultra-thin regions on an exposed electrically insulating layer structure. Actually, such metal particles or ions can be also from a seed layer formed by electroless plating during creating at least part of an electrically conductive layer structure and it may migrate to one or more adjacent layers.

In the context of the present application, the term "main surface" of a body may particularly denote one of two largest opposing surfaces of the body or outermost opposing surfaces of the body. The main surfaces may be connected by circumferential side walls. The thickness of a body, such as the component carrier or the stack or a layer structure thereof, may be defined by the distance between the two opposing main surfaces.

According to an exemplary embodiment, a component carrier (such as a printed circuit board or an integrated circuit substrate) may comprise a layer stack (such as a laminate). Said stack may be made of one or more electrically conductive layer structures (for instance comprising pads, traces, vertical through connections, etc.) and electrically insulating layer structures (for example resin sheets, optionally comprising reinforcing structures such as glass fibers or glass spheres and/or filler particles, for instance for adjusting thermal conductivity). Said at least one electrically conductive layer structure may be provided (for instance in form of one or more pads) partially or entirely on and/or in a main surface of an exposed one of said plurality of electrically insulating layer structures. A surface finish layer may cover an exposed surface of the electrically conductive layer structure, in particular for protection purposes and/or for promoting electric connection thereof. Advantageously, the main surface of the electrically insulating layer structure may be configured or functionalized so as to suppress or eliminate attraction and attachment of parasitic metallic residues on said main surface. For instance, such a metallic residue or medium may remain as a relict from previous processes, for instance the formation of a seed layer for forming a part of the at least one electrically conductive layer structure and/or formation of the surface finish layer. For instance, palladium ions from a seed layer deposition process and/or gold from a surface finishing process may tend to remain artificially or undesired on surface portions of a dielectric surface after seed layer formation and/or surface finish layer formation and may act as a basis for the creation of an electrically conductive layer structure. By specifically configuring or functionalizing at least a surface portion of the at least one electrically insulating layer structure adjacent to the main surface, metallic ions or particles may be hindered from accumulating at undesired surface portions, for instance on a dielectric surface between adjacent pads. Various options for configuring or functionalizing the main surface portion have been discovered by the present inventors. For example, the material of the at least one electrically insulating layer structure juxtaposed to said main surface may be selected accordingly, for instance may be made of a low Df material. It may also be possible to adjust the surface topography or morphology of the main surface for inhibiting or hindering metallic particles from accumulating there, for instance by adjusting roughness Rz, filler particles content and/or surface coverage, etc. By preventing metal accumulation between sub-structures of the at least one electrically conductive layer structure on an electrically insulating surface in between, the distance between adjacent electrically conductive sections (for instance pads) may be advantageously reduced. Beneficially, this may allow to miniaturize the component carrier and to create fine-line structures.

In the following, further exemplary embodiments of the component carrier and the method will be explained.

In an embodiment, said main surface is configured to inhibit said attraction and attachment by providing said one of said plurality of electrically insulating layer structures of a low Df material. Df, also denoted as loss tangent, may be a measure of a material's ability to dissipate electrical energy as heat when it is exposed to an alternating electric field. Df (which may also be denoted as dissipation factor) is a measure of energy lost during the reversal of electric polarization in the dielectric material. It is expressed as a fractional energy loss. A low Df material may denote a material having a lower Df value with lower loss than standard prepreg, in particular having a Df value of less than 0.022. The smaller the value, the smaller will be the energy loss during transmission. Therefore, the low Df material is significantly important at high frequency and high speed applications as it can ensure the signal transmission integrity and the excellent function of the product in an efficient manner. Using a low Df material for an exposed electrically insulating layer structure in direct physical contact with an exposed pad of a layer stack has turned out as a powerful mechanism to inhibit attraction and attachment of metal ions and/or metal particles on a main surface of said electrically insulating layer structure.

In an embodiment, said main surface is configured to inhibit said attraction and attachment by providing said one of said plurality of electrically insulating layer structures of a material having a Df value of less than 0.022, in particular having a Df value of less than 0.018, more particularly having a Df value in a range from 0.002 to 0.022. For example, a GL107 Ajinomoto Build-up Film (ABF) is an excellent choice for such an electrically insulating layer structure with low Df value. This may efficiently suppress attraction and attachment of metal ions and/or metal particles on a main surface of said electrically insulating layer structure. As a result, very small pad dimension and pad-to-pad distance may be achieved without compromising on electrical performance.

In an embodiment, said main surface is configured to inhibit said attraction and attachment by providing said one of said plurality of electrically insulating layer structures with high content of filler particles. A high amount of filler particles, in particular when made of glass, may reduce the accumulation of electric charges at an exposed dielectric main surface and may thus hinder accumulation of metallic particles at such a surface.

In an embodiment, said main surface is configured to inhibit said attraction and attachment by providing said one of said plurality of electrically insulating layer structures with a content of filler particles of at least 70 volume percent in relation to an entire volume of said one of said plurality of electrically insulating layer structures. Preferably, said content of filler particles may be even at least 80 volume percent. With such a high degree of filler particles, metal accumulation at a dielectric main surface of a laminated layer stack may also be efficiently suppressed. The high volume of the filler particles distributed in the insulating layer structure can also impact the polarity of the insulating material, which may finally impact the Df property of the insulating material.

In an embodiment, said main surface is configured to inhibit said attraction and attachment by providing said main surface with a low roughness Rz. In particular, said main surface may be configured to inhibit said attraction and attachment by providing said main surface with a roughness Rz of less than 1000 nm. Preferably, said roughness Rz may be even less than 800 nm. A corresponding smooth surface may also have a positive impact on the inhibition of attraction and attachment of metal ions and/or metal particles on said main surface. As higher roughness Rz values may indicate greater peak-to-valley variations on the surface, this can increase the overall surface area. This increased surface area can enhance ion absorption as there may be more sites available for the ions to interact with. Beside that the surface roughness can create interference effects that may modify the absorption characteristics of the surface, thereby influencing the absorption and distribution of ions across the surface. Additionally or alternatively, the rough surface can have more defect sites, which can act as traps for ions, thereby enhancing absorption. Furthermore, the roughness may also impact the surface energy, wherein higher roughness may cause higher surface energy, which can attract and retain ions more effectively.

In an embodiment, said one of said plurality of electrically insulating layer structures having said main surface is made of a material having a Df value at least 10% below a Df value of another one of said plurality of electrically insulating layer structures below said main surface. Preferably, said difference may be at least 20%. For instance, an electrically insulating layer structure in direct physical contact with an exposed pad and being exposed itself may be provided of a dielectric resin having a lower Df value compared with another electrically insulating layer structure in an interior of the stack. Consequently, the latter electrically insulating layer structure may be manufactured with low effort using a standard dielectric, whereas the former electrically insulating layer structure may suppress undesired accumulation of metallic particles at a stack surface by being made of a sufficiently low Df value. With such kind of configuration of the product, a high density with fine line structuring can be produced with a lower effort. Additionally or alternatively, with different dielectric material at different layers in the component carrier, warpage may also be reduced by compensating the Young's modulus of different material.

In an embodiment, said main surface of said one of said plurality of electrically insulating layer structures has a ratio of a partial filler surface area divided by a partial resin surface area in a range from 10% to 80%, in particular at least 60%. Thus, the partial area of the main surface occupied by the fillers exposed at the main surface divided by the partial area of the main surface occupied by resin material of the electrically insulating layer structure may be in the mentioned ranges. Descriptively speaking, a high partial area of the fillers (in particular when made of glass) at the main surface may lead advantageously to a low tendency of metallic particles to accumulate at said main surface. Since there may be a high partial area of fillers with very smooth surface exposed on said main surface after an etching process (such as dry etching or wet etching), it may be difficult for the metallic particles to attach to the smooth surface of the fillers. Therefore, the high partial area of fillers in the insulating layer structure can impact the attraction and attachment of the metallic particles on the main surface.

In an embodiment, said main surface is configured to inhibit said attraction and attachment by depleting said main surface of electric charge carriers, in particular by providing said main surface free of electric charge carriers. Any measure taken to reduce the amount of electric charge carriers at or close to the main surface may be beneficial for inhibiting attraction and attachment of metal ions and/or metal particles on said main surface. Therefore, the fine line structuring can be formed without additional process to reduce the electric charge and the risk of short circuiting of two pads connected.

In an embodiment, said main surface is configured to inhibit said attraction and attachment by rendering said main surface hydrophobic. For instance, such a hydrophobic property may be achieved by a corresponding surface treatment of the main surface or by a hydrophobic coating. Hydrophobic material tends to prefer other neutral material rather than charged material. A non-polar property at the main surface may reduce an undesired accumulation of metallic ions in this region by enhancing hydrophobicity. The hydrophobic morphology at said main surface can also reduce the risk of metal growing on the surface, which can ensure that the two pads will not be connected due to the metal ion reacting with other chemical in an electroless process.

In an embodiment, said main surface is configured to inhibit said attraction and attachment by being treated to generate low van der Waals forces. For instance, such a surface characteristics may be achieved by a corresponding surface treatment of the main surface. In the absence of large van der Waals forces at the main surface, undesired accumulation of metallic ions on this main surface may be efficiently suppressed.

It is believed that low van der Waals forces may be a root cause for inhibiting attraction of metal ions. The ability of non-polar molecules to be polarized by field-induced separation of charges can indirectly influence the adsorption onto a palladium surface for the following reasons: When a non-polar molecule is placed in an electric field, the electron cloud within the molecule may be distorted. This may create a temporary separation of charge, which may result, in turn, in an induced dipole moment. Moreover, it is believed that van der Waals forces may have an impact on palladium surface interactions, since palladium surfaces can have localized charge distributions or may create electric fields due to their electronic structure. Beyond this, van der Waals forces may influence electrostatic interactions, as an induced dipole moment in a non-polar molecule can interact with the electric field or charge distribution on the palladium surface. Furthermore, these electrostatic interactions can contribute to the overall forces that govern the adsorption of the molecule onto the palladium surface. The influence of induced dipole moments on adsorption may be generally weaker compared to other forces like van der Waals forces or specific chemical interactions. A primary factor influencing adsorption may be the overall molecular structure and the presence of functional groups that can interact specifically with the palladium surface. Furthermore, the actual adsorption process may be a complex interplay of various forces, and the contribution of induced dipole moments may vary depending on the specific molecule and the conditions of the adsorption experiment. In a nutshell, while the ability of non-polar molecules to be polarized by an electric field can contribute to their interaction with a palladium surface, it may be a secondary factor compared to other intermolecular forces.

In an embodiment, the at least one electrically conductive layer structure comprises a seed layer and at least one plated layer. A seed layer may be a thin-film of electrically conductive material deposited directly on a dielectric surface for forming the basis of a subsequently deposited electrically conductive plating layer which may be formed by electroplating. For instance, such a seed layer may comprise palladium being appropriate for depositing copper thereon. For instance, a plating layer may be formed on a seed layer by galvanic deposition. The palladium ion may immigrate to the adjacent dielectric layer and remains on the adjacent dielectric layer so that the palladium ion beside the pad is likely to react with the metal ion in the ENEPIG chemistry to cause overplating between two metal pads. Therefore, it may finally lead to short circuiting between two pads.

In an embodiment, the metal ions and/or metal particles are of a metal forming at least one constituent of the at least one electrically conductive layer structure, in particular a seed layer of the at least one electrically conductive layer structure, and/or of the surface finish layer. In particular, the at least one constituent may comprise palladium. While palladium may be helpful to act as a seed layer for subsequent copper deposition, palladium residues on undesired surface portions of a main surface of an exposed electrically insulating layer structure of the stack may lead to undesired metal formation (for instance during a surface finishing process to cause overplating between pads within one opening and then cause electrical performance issue such as short) on such a main surface. According to exemplary embodiments, a configuration or functionalization of said main surface may advantageously suppress such undesired phenomena. Therefore, the risk of the electrical performance on the product can be avoided for fine line structuring and high density products with lowest effort.

In an embodiment, the main surface of the one of said plurality of electrically insulating layer structures is configured to inhibit attraction and attachment of palladium ions and/or palladium particles on said main surface. Since such palladium particles on the main surface apart from pad regions may lead to metallic (in particular gold) deposition during a surface finishing process which may unintentionally connect electrically decoupled pads with each other, measures taken according to exemplary embodiments of the invention to inhibit attraction and attachment of metal ions and/or metal particles on said main surface may be of utmost advantage. Such kind of measure may cause small or even minimum effort, so the manufacturing effort may be controlled, while good quality can be ensured. This may provide a big advantage for the high volume manufacturing of high performance computing products.

In an embodiment, the one of said plurality of electrically insulating layer structures comprises filler particles at the main surface which are configured to promote the inhibition of said attraction and attachment. Hence, such filler particles may fulfil a double function. On the one hand, filler particles may be added to a base resin of an electrically insulating layer structure for fine-tuning its physical properties, for instance to enhance thermal connectivity, robustness or flexibility. Simultaneously, said filler particles may be synergistically used for hindering metallic particles from attracting and attaching to a main surface of an exposed electrically insulating layer structure, since filler particles - in particular when present close to or at the main surface - may reduce the local presence of electric charge carriers.

In an embodiment, the main surface of the one of said plurality of electrically insulating layer structures is configured to inhibit said attraction and attachment of metal ions and/or metal particles on said main surface more than on another main surface of said one of said plurality of electrically insulating layer structures and/or more than on a main surface of another one or said electrically insulating layer structures. Thus, the configuration or functionalization of the exposed main surface of an electrically insulating layer structure of the stack inhibiting attraction and attachment of metal ions and/or metal particles on said main surface may be absent of its opposing main surface facing an interior of the stack. Such a configuration or functionalization may also be absent on a main surface of another electrically insulating layer structure of the stack apart from the exposed one with its main surface.

In an embodiment, at the back side, one electrically insulating layer may be provided with the function of inhibiting attraction and attachment of metal ions and/or metal particles on an exposed surface. One opening may comprise more than two pads with total exposure in the opening of solder resist material. An opposite surface of the electrically insulating layer may comprise an electrically insulating layer which may for instance be embodied as ordinary prepreg or resin. One opening of the solder resist layer may only comprise one pad, wherein at least one portion of the pad may be embedded in one electrically insulating layer. With such kind of design, high density and fine line structuring component carriers can be realized with a low manufacturing effort and good quality.

In an embodiment, front side and back side of the stack may both comprise low Df material at an exterior layer (in particular a layer below the solder resist layer). Furthermore, more than one pad may be formed on the main surface exposed in an opening of the solder resist layer. Advantageously, such kind of design can achieve high density and fine line structuring.

In an embodiment, an entire dielectric material of a build-up layer can be made of low Df material, and only on a back side metal-defined pads may be provided on the main surface. Such kind of design can significantly improve the integrity of signal transmission with high frequency. Such an embodiment is particularly advantageously applicable for high performance computing.

In an embodiment, exposed material of the one of said plurality of electrically insulating layer structures defining at least part of said main surface is different from material of another one of said electrically insulating layer structures. Advantageously, the dielectric material of different electrically insulating layer structures of the stack may be selected differently. For instance, an electrically insulating layer structure with an exterior main surface at which one or more metallic pads are present may be made of a material having a lower Df value compared with another electrically insulating layer structure of the same stack being arranged remotely from said exterior main surface in an interior of the stack. This may allow to specifically adapt the dielectric layer with the exposed main surface for suppressing undesired metal accumulation between metallic pads at this main surface, while simultaneously having the freedom to select dielectric material of another electrically insulating layer structure (in particular another electrically insulating layer structure directly connected to the electrically insulating layer structure with the exposed main surface) differently. This may allow to select said other material in accordance with other tasks, for instance for reducing manufacturing effort and reduce the risk of electrical performance issue for more advanced product, and/or for enhancing thermal conductivity, rigidity or flexibility. In order to ensure a proper warpage performance of the component carrier, the different insulating layers may be provided to have different values of the Young modulus so that the combination of different material with different values of the Young modulus can be selected to compensate the CTE (coefficient of thermal expansion) mismatch of the different material. Thus, a proper control of warpage may be possible.

In an embodiment, the one of said electrically insulating layer structures defining the main surface is part of a redistribution structure together with said at least one electrically conductive layer structure. Such a redistribution structure may be an electrically conductive wiring in a dielectric matrix acting as an electric transition structure between a first interface (for instance to an electronic component to be surface mounted on the component carrier) and a second interface (for instance to a mounting base, such as a printed circuit board, on which the component carrier is to be mounted). For instance, a redistribution structure (in particular a redistribution layer) may be an electric interface between a region with a higher integration density (for instance to be coupled with a semiconductor die) and a region with a lower integration density (for instance to be coupled with a printed circuit board). By embedding a redistribution structure at least partially in a low Df material, low losses may be combined with a desired tendency to inhibit attraction and attachment of metal ions and/or metal particles on a main surface of said low Df material.

In an embodiment, said redistribution structure comprises another of said electrically insulating layer structures with a different material and/or with different main surface interaction characteristics compared with said one of said plurality of the electrically insulating layer structures defining the main surface. Hence, another part of the redistribution structure may be embedded in another dielectric material than the low Df material. As a result, a redistribution structure with inhomogeneous dielectric surrounding may be obtained, for instance allowing to adjust different properties in different regions.

In an embodiment, the surface finish layer is in contact with the main surface. In particular, the surface finish layer may be partially in direct physical contact with the main surface of the exposed electrically insulating layer structure and may be partially in direct physical contact with an exposed surface (in particular an exposed pad surface) of the electrically conductive layer structure of the stack. Although the surface finish layer may be predominantly formed on said electrically conductive layer structure, an annular end section thereof may extend up to the dielectric stack surface.

In an embodiment, said at least one electrically conductive layer structure comprises at least two sub-portions arranged side-by-side, wherein a portion of said main surface between different sub-portions defines a first area with metallic material of the surface finish layer. Additionally or alternatively, said at least one electrically conductive layer structure comprises at least two sub-portions arranged side-by-side, wherein a portion of said main surface between different sub-portions defines a second area free of metallic material. For instance, the different sub-portions relate to adjacent exposed pads covered with surface finish material. In between, an exposed portion of the main surface of the outermost electrically insulating layer structure in a central region between adjacent pads may form the second area being free of metallic material, thereby electrically decoupling adjacent pads. Between pads and such a metal-free dielectric surface portion, surface finish material on the dielectric main surface may form a respective first area. Such kind of design may provide the advantage that said electrically conductive layer structure (in particular comprising the pads) can be soldered with more area, as it does not only solder with the whole surface of the electrically conductive layer structure, but also solder with the lateral sidewall of the electrically conductive layer structure. Therefore, the bonding performance can be improved and a crack issue between said electrically conductive layer structures can be controlled.

In an embodiment, said second area is arranged between two of said first areas. Advantageously, such a metal-free second area may electrically decouple laterally adjacent sub-portions of the at least one electrically conductive layer structure, for instance may keep different pads separate from each other. This may ensure proper electric functioning of the component carrier. Additionally, such kind of design can realize smaller pads and may increase the density of the routing layer. This may also distribute stress between the insulating material and the metal so that delamination or crack tendency resulting from the thermal treatment may be reduced.

In an embodiment, said second area has a larger planar extension than said first area. The planar extension between the two sub-portions may thus be free of undesired metallic coverage to a large extent. When such a planar extension is sufficiently large, a high electric reliability may be achieved.

In an embodiment, each of said first area and said second area is covered by a protection structure. In particular, said protection structure may be an outermost insulating protection layer, in particular a solder resist, of the stack. Alternatively, said protection structure may be a mold compound molded around said at last two sub-portions. Such an electrically insulating protection structure may protect the stack with regard to an environment, for instance against mechanical impact, oxidation and/or an undesired coverage by material such as solder. This may increase the freedom of design during a manufacturing process and may allow to use the component carrier even under harsh conditions.

In an embodiment, the first area and the second area are configured so that an electric conduction between the two sub-portions is disabled. In particular, said at least two sub-portions may comprise metallic pads. A second area located at the dielectric main surface between pads related to first areas and being reliably free of parasitic metallic coverage may reliably ensure electric integrity of the component carrier. Normally the end of the pad may be embedded in the insulating material, so that it may be impacted by thermal stress at the connection area between the insulating material and metallic pads. However, exemplary embodiments of the invention can reduce or even eliminate such an impact so that delamination or cracks at the connection area between the insulating material and the metallic pads can be avoided.

In an embodiment, a distance between said pads is lower than 130 µm, in particular is in a range from 30 µm to 70 µm. Preferably, said distance may be in a range from 30 µm to 50 µm. This can be the distance between the two sub-portions. More specifically, this can be the lateral or horizontal distance from a sidewall of a pad to an adjacent sidewall of an adjacent pad. Advantageously, said distance may be very small, and may be smaller than in conventional approaches. This is due to the fact that, in view of the configuration or functionalization of the exposed electrically insulating layer structure's exposed main surface to inhibit attraction and attachment of metal ions and/or metal particles on said main surface, an undesired, parasitic or artificial electric coupling between adjacent pads on said main surface by undesired, parasitic or artificial metal on said main surface between said pads may be reliably prevented.

In an embodiment, a diameter of said pads is lower than 300 µm, in particular is lower than 100 µm. This can be the maximum horizontal diameter of a respective pad. Advantageously, said diameter may be very small, and may be smaller than in conventional approaches. This is due to the fact that, in view of the configuration or functionalization of the exposed electrically insulating layer structure's exposed main surface to inhibit attraction and attachment of metal ions and/or metal particles on said main surface, the dimension of metallic structures of the component carrier may be significantly reduced without compromising on electric reliability.

In an embodiment, the method comprises removing, in particular stripping, metal ions and/or metal particles, in particular palladium ions and/or palladium particles, from at least part of said main surface. Advantageously, a very simple metallic material stripping process may be carried out on said main surface thanks to the configuration or functionalization of said main surface to inhibit attraction and attachment of metal ions and/or metal particles on said main surface. For instance, only a simple or single (or single stage) metal stripping process on said main surface may be carried out.

In an embodiment, the component carrier comprises a stack of a plurality of electrically insulating layer structures and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. In particular a naked die as example for an electronic component can be surface mounted on a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In an embodiment, the component carrier is an integrated circuit substrate. In the context of the present application, the term "integrated circuit substrate" (IC substrate) may particularly denote a component carrier having a size and a pitch adjusted to the requirements of an integrated circuit component (in particular a semiconductor chip) mounted thereon. An IC substrate may be a, in relation to a PCB, comparably small component carrier onto which one or more integrated circuit components may be mounted and that may act as a connection body between one or more chip(s) and a PCB or being plugged in a socket mounted on a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of some kind of PCBs may be at least 200 µm, in particular at least 300 µm.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocy-clobutene (BCB) and/or a combination thereof. Reinforcing layer structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These pre-pregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium, molybdenum and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP), and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectrome-chanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferro-ic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of a component carrier according to an exemplary embodiment of the invention.
Figure 2 illustrates a cross-sectional view of a component carrier according to another exemplary embodiment of the invention.
Figures 3 to 8 illustrate plan views of component carriers according to exemplary embodiments of the invention.
Figures 9 and 10 show diagrams indicating metal presence on a surface of component carriers according to exemplary embodiments of the invention.
Figure 11 illustrates a manufacturing architecture of manufacturing a component carrier according to an exemplary embodiment of the invention.

The illustrations in the drawings are schematic. In different drawings, similar or identical elements are provided with the same reference signs.

When creating metal-defined pads (in particular on the back side) of a component carrier, the pad size and the pad space need to be big in conventional approaches. Small pad sizes and pad spaces are difficult to achieve if not impossible in conventional approaches also in view of a palladium strip process which may be carried out as a two times palladium strip process. In such a scenario, a palladium strip process in the context of seed layer formation may be difficult and cumbersome. Moreover, a two times palladium process does not only increase the effort of the manufacturing considering the needed more amount of chemistry, but also may increase the risk of product quality with one more time dipping in the chemistry. A resin sheet material may be used for the electrically insulating layers. In particular, the same resin sheet material may be used for all electrically insulating layers.

However, there is a trend of smaller packages dedicated to smaller space available for installing devices. Correspondingly, component carriers such as integrated circuit (IC) substrates needs to be improved and upgraded with smaller size simultaneously. In particular, on the back side of such a component carrier, a metal-defined pad size and space should be reduced synchronously to meet demanding specifications. This is, however, difficult to achieve, if not impossible, with conventional approaches. Beside that design of the metal-defined pads on the back side can also simplify the assembly between the IC substrate and motherboard as the metal defined pads can realize the mounting by a pin instead of the soldering.

According to an exemplary embodiment of the invention, a component carrier (for example a PCB) may comprise a (preferably laminated) layer stack. The stack may comprise electrically conductive layer structures (for instance comprising pads to be interconnected, for instance by soldering, with another electronic system such as a surface mounted electronic component). The stack may also comprise one or more electrically insulating layer structures (for instance organic sheets with inorganic fillers). A surface finish layer, for instance formed of ENEPIG, may coat and protect an exterior surface of the electrically conductive layer structure(s). Beneficially, the exposed main surface of the electrically insulating layer structure between sections of an electrically conductive layer structure covered by surface finish may be specifically configured or functionalized for hindering attraction and attachment of metallic ions and other metallic particles on the exposed dielectric main surface. Such metallic ions and other metallic particles may be side effects of seed layer formation and/or surface finish layer formation processes. By selecting and correspondingly adjusting surface region properties of at least one electrically insulating layer structure delimiting the main surface, any undesired metallization between electrically conductive layer structure sections may be prevented partially or entirely. For example, this may be accomplished by correspondingly selecting the material of the at least one electrically insulating layer structure next to said main surface, for example of a low Df material. A suitable configuration of the surface topography and morphology of the main surface may be effective as well, for instance an adjustment of the surface properties of filler particles in a resin matrix of the exposed electrically insulating layer structure. By hindering metal presence (for instance palladium from a seed process and/or gold from a surface finish process) around the at least one electrically conductive layer structure on an electrically insulating surface, the line space ratio and/or one or more other characteristic dimensions of the component carrier and in particular pads thereof may be reduced, hence also reducing or even eliminating the risk of electrical defects such as a short between two pads connected by the deposition of metal between the two pads due to the palladium remained on the insulating layer catalyzing the reaction of other metal. This may allow to provide a component carrier with fine line structuring with a low effort.

According to an exemplary embodiment, metal-defined pads on a component carrier, in particular on the back side of a component carrier such as an integrated circuit substrate, may be formed using low Df resin sheet material on underlying layers. For instance, such resin sheet material may use Ajinomoto Build-up Film^{®} (ABF) with low Df properties or other insulating material with low Df property. With such a material selection of one or more electrically insulating layer structures beneath an exposed pad of one or more electrically conductive layer structures, attraction and attachment of metal ions and/or metal particles on a main surface of a respective electrically insulating layer structure may be significantly suppressed.

Exemplary embodiments of the invention may have advantages: In particular, by inhibiting or hindering metal formation on a main surface of an electrically insulating layer structure adjacent to one or more metal-defined pads, a pad-to-pad space can be reduced, for instance up to 30 µm or even less. It may also be possible to reduce a metal-defined pad size up to 77 µm or even less. Moreover, such a manufacturing architecture may make it possible to omit one palladium strip process, or at least significantly simplify palladium stripping. Furthermore, there may be the possibility of reducing substrate and component size. This may also lead to a reduction of the manufacturing effort due to a smaller size of a component carrier and its sub-structures. Advantageously, this may also lead to lower power consumption.

Without wishing to be bound to a specific theory, it is presently believed that the dielectric constant (Df) of a material and its ability to adsorb palladium colloids in the absence of an electrostatic field may have an indirect relationship. It is believed that this is because the dielectric constant (or permittivity) of a material reflects its ability to store electrical energy within an electric field. This is considered to be related to the material's polarizability, i.e. how easy its electron distribution can be distorted by an external field. There is also an indirect influence on adsorption: While probably not being the primary driver, a higher dielectric constant generally implies greater polarizability. This may influence the strength of van der Waals forces, which may play a role in palladium adsorption. Concerning surface charge, a higher dielectric constant may be associated with a higher surface charge density. This can, in turn, influence electrostatic interactions with the palladium colloid. However, other factors may dominate palladium adsorption: Van der Waals forces may be the most significant forces driving adsorption in many cases. For non-polar surfaces and media, hydrophobic interactions may be important. If the surface contains aromatic groups, n-n ("pi-pi") interactions may play a major role. Surface chemistry and topography may also significantly influence adsorption. In summary, while the dielectric constant can have an indirect influence on palladium adsorption, it is not believed to be the primary determinant. Dominant factors are believed to be the various intermolecular forces, surface properties, and the nature of the surrounding medium. Thus, the relationship between dielectric constant and palladium adsorption may be moderate and may be overshadowed by other, more significant factors governing the adsorption process.

It is believed that the Df value of a material of electrically insulating layer structures of a component carrier may have an impact on attraction and attachment of metal ions and/or metal particles on a main surface of an exposed electrically insulating layer structure. For instance, the GX, GY, and GL series from Ajinomoto Fine-Techno are all types of build-up films (ABF) which may be advantageously used in the manufacturing of printed circuit boards (PCBs) and other component carriers. Materials of the different series may have different properties. The GX series uses an epoxy-based base resin. Features of such materials are a good balance of properties, and a suitability for general-purpose applications. Such materials may be used for various PCB applications. Materials of the GY series may use a base resin in the form of a blend of epoxy and cyanate ester resins. Such materials may lead to an enhanced thermal stability and lower dielectric constant (Dk) compared to the GX series, making it even better suitable for higher-frequency applications. In particular, such materials may be used in applications where signal integrity is critical, such as high-speed digital circuits and microwave devices. Materials of the GL series may use, as base resin, a proprietary blend with a focus on low dielectric loss (Df). Features of such materials are a very low Df value, enabling reduced signal transmission loss, and making it suitable for high-frequency and high-speed applications. Exemplary applications using such materials are demanding applications where signal integrity and low loss are paramount, such as 5G communication devices and high-performance computing systems. In summary, GX materials may be used for general purpose, and allow to achieve a good balance of properties. GY materials may result in an improved thermal stability and lower Dk value for higher-frequency applications. GL materials may lead to ultra-low Df values and may be implemented for critical signal integrity in high-speed applications.

In view of the foregoing, an exemplary embodiment of the invention may use different dielectric materials with different Df values for different dielectric layers of a component carrier for inhibiting attraction and attachment of metal ions and/or metal particles on a main surface of an exposed dielectric material. Descriptively speaking, the Df value may indicate how stable a dielectric material behaves in an electric field. The lower the Df value, the more stable may be the behavior. When an electric cloud in a dielectric material is less mobile, an undesired motion of electric charge carriers to palladium on a dielectric surface may be suppressed, so that adsorption of palladium on a main surface of an electrically insulating layer structure may be reduced. Thus, palladium can be easier removed in a subsequent process. Consequently, pads may be made smaller and/or can be arranged closer to each other. For copper pad creation, palladium as a catalyzer in seed layer deposition may be used. However, such a palladium may migrate to the insulating layer and may remain thereon, which may be disturbing for subsequent surface finish formation. This may conventionally limit an achievable pad-to-pad distance. By using low Df dielectric material for at least part of the electrically insulating layer structures of a stack, an interaction of electric charge with palladium may be suppressed, so that a low pad-to-pad distance may become possible.

However, Df adjustment of one or more electrically insulating layer structures of a component carrier are only one embodiment for hindering or inhibiting attraction and attachment of metal ions and/or metal particles on a main surface of an exterior electrically insulating layer structure. In this context, a value of the low Df dielectric material may be preferably smaller than or equal to 0.018. It may also be advantageous when the Df value of the exposed electrically insulating layer structure is at least 10% smaller than the Df value of an underlying electrically insulating layer structure. Additionally or alternatively, one or more further measures can be taken for this purpose. For instance, a high amount of exposed fillers at the exposed main surface of the electrically insulating layer structure may also allow to hinder or inhibit metal particle attraction to the dielectric surface. For example, the exposed electrically insulating layer structure may have at least 70 volume percent particles, in particular glass particles. The glass particles volume and distribution may change the polarity and then impact the Df of the material. It may also be advantageous when a ratio between a partial filler area and a resin-defined surface area of the exposed electrically insulating layer structure may be in a range from 10% to 80%. For instance, exposed glass particles may have a positive effect because there is substantially no charge accommodation on such a glass surface. Also a low roughness Rz at said exposed dielectric main surface may have a positive impact, because it may improve the efficiency of stripping palladium. For instance, it may be advantageous when the roughness Rz is below 1000 nm. Thus, adjustment of the surface morphology may also allow to inhibit or hinder attraction and attachment of metallic particles on an exposed electrically insulating main surface.

In particular, exemplary embodiments may provide a component carrier with a metal-defined pad design in combination with different laminated electrically insulating layer structures, for instance including ABF and/or a low Df material at least at an exposed main surface. More generally, an exemplary embodiment of the invention may reduce the back side metal-defined pad space with a mixed structure substrate. For instance, an electrically insulating layer structure with low Df resin may be arranged on the exposed back side of the component carrier. This may allow to achieve a smaller metal-defined pad space. Consequently, it may be possible to obtain improvements in terms of signal transmission capability. Advantageously, it may be possible to use less filling dielectric material due to a smaller space metal-defined pad. A desired Df value of at least one of the electrically insulating layer structures (in particular an exposed electrically insulating layer structure) may be for instance in a range from 0.003 to 0.0022, in particular smaller than 0.0022. A gist of an exemplary embodiment may be to use a low Df ABF on a substrate to reduce or even minimize a metal-defined pad space. Exemplary embodiments may offer the possibility to remove a palladium strip process with big metal-defined pad design. This may help to increase the run rate and trigger saving of manufacturing effort. Moreover, fine line structuring for substrates may become possible.

According to an exemplary embodiment of the invention, a component carrier is provided which comprises a stack comprising at least one electrically conductive layer structure and a plurality of electrically insulating layer structures. Said at least one electrically conductive layer structure may be provided on or in a main surface of one of said plurality of electrically insulating layer structures and may comprise an exposed surface at least partially covered by a surface finish layer. The main surface of the one of said plurality of electrically insulating layer structures may be configured to hinder metal ions and/or metal particles attraction and attachment on said surface.

In an embodiment, it may be possible to hinder metal ions and/or metal particles attraction and attachment. The kind of exposed material may comprise low Df material (which may enhance said hindering), and/or fillers (which may decrease the hindering). The kind of exposed surface may be adapted concerning roughness, may include low to no electric charge, may experience low Van der Waals forces, and/or may be a hydrophobic surface.

In an embodiment, the at least one electrically conductive layer structure may comprise a seed layer (wherein metallic material (such as particles) forming the seed layer can be deposited or provided on the main surface of the electrically insulating layer structure, whereas the main surface may be configured to hinder the metal ion attraction and attachment) and at least one plated layer. For instance, the ions may be of the metal of at least one constituent of the at least one electrically conductive layer structure on the main surface. It may also be possible that the ions are of the seed layer. Additionally or alternatively, the ions may be a constituent of the surface finish layer. For instance, the ions may comprise or consist of palladium.

For example, fillers (or filler particles) at the main surface may affect the hindering of metal ions attraction and attachment. In an embodiment, the main surface of the one of said plurality of electrically insulating layer structures is configured to hinder the metal ions attraction and attachment on said surface more than the other main surface or the main surfaces of a further (i.e. the adjacent one) electrically insulating layer structures of the stack. For example, the exposed material of the electrically insulating layer structure defining the main surface is different from the material of a further (i.e. the adjacent one) electrically insulating layer structure composing the stack. In an embodiment, the electrically insulating layer structure defining the main surface is part of a redistribution layer. In particular, said redistribution layer comprises at least one further electrically insulating layer structure with a different material and/or with different main surface interaction with respect to the one of said plurality of the electrically insulating layer structures defining the main surface. For instance, the surface finish layer is in contact with the main surface. For example, said at least one electrically conductive layer structure on or in a main surface of one of said plurality of electrically insulating layer structures comprises at least two sub-portions provided one beside the other, wherein in particular the main surface between these two sub-portions comprises a first area with a low amount of metal particles and/or metal ions and/or composition of the surface finishing layer. In an embodiment, said at least one electrically conductive layer structure on or in a main surface of one of said plurality of electrically insulating layer structures comprises at least two sub-portions provided one beside the other, wherein in particular the main surface between these two sub-portions comprises a second area free of particles and/or metal ions and/or composition of the surface finishing layer. For instance, the second area may be arranged between two first areas. For example, the second area has a higher planar extension than that of the first area. In an embodiment, each of said first and second area are covered by a protection material. For example, the protection material may be from the outermost insulating (for instance protection, such as solder resist) layer of the stack. Advantageously, a material may be molded around said at least two sub-portions. In an embodiment, the sub-portions comprise pads. For instance, the extension and the distribution of the first and the second areas is such that an electric conduction between the two sub-portions is prevented. In an embodiment, a relationship between the diameters, the thickness and the distance of the pads, the copper and a Pd-Au layer may be adjusted to match with each other.

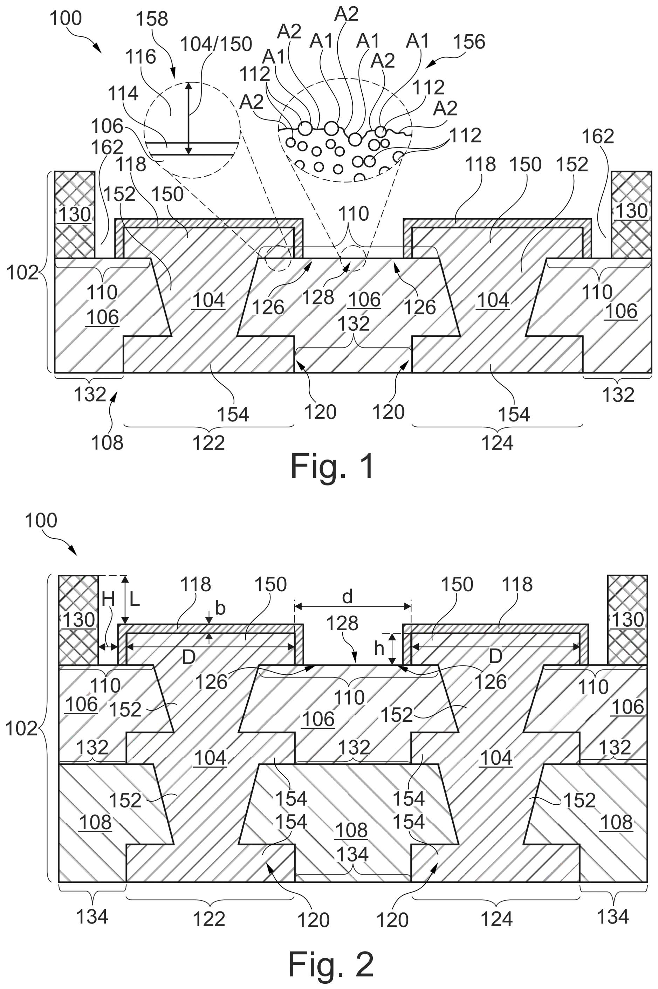

**Figure 1** illustrates a cross-sectional view of a component carrier 100 according to an exemplary embodiment of the invention.

Component carrier 100 may be an integrated circuit (IC) substrate or a printed circuit board (PCB). The component carrier 100 may comprise a laminated layer stack 102 comprising electrically conductive layer structures 104 and electrically insulating layer structures 106, 108. For example, the electrically conductive layer structures 104 may comprise patterned metal layers (such as patterned copper foils or patterned deposited copper layers) and vertical through connections, for example copper filled vias, which may be created by drilling and plating. The electrically insulating layer structures 106, 108 may comprise a respective resin (such as a respective epoxy resin), preferably comprising reinforcing particles therein (for instance glass fibers or glass spheres). For example, the electrically insulating layer structures 106, 108 may be made of prepreg or FR4 or ABF. The electrically insulating layer structures 106, 108 may also comprise resin layers being free of glass (in particular glass fibers).

As shown in Figure 1, the uppermost electrically conductive layer structure 104 of stack 102 extends up to and vertically beyond a main surface 110 of the partially exposed electrically insulating layer structure 106. More specifically, the electrically conductive layer structures 104 may comprise exteriorly accessible pads 150 vertically above vertical through connections 152, which may be embodied as copper-filled laser vias embedded in the electrically insulating layer structures 106, 108. In the shown embodiment, further embedded pads 154 are arranged below and are vertically connected with said vertical through connections 152. The electrically insulating layer structures 106, 108 defining the main surface 110 may form a redistribution structure 120 together with said electrically conductive layer structures 104.

Now referring to a detail 158 of Figure 1, the uppermost electrically conductive layer structure 104 and more specifically its pad 150 comprises a seed layer 114 directly on electrically insulating layer structure 106 and comprises one or more plated layers 116 thereon. For example, seed layer 114 may be formed by electroless plating. For instance, the one or more plated layers 116 may be formed by electroplating, for example by galvanic plating.

Still referring to Figure 1, a surface finish layer 118 is provided which covers an exposed surface of the pads 150 of the electrically conductive layer structure 104. The surface finish layer 118 may also cover a portion of the main surface 110 of the partially exposed electrically insulating layer structure 106. In other words, the surface finish layer 118 is in contact with the main surface 110. For example, the surface finish layer 118 may be made of an electrically conductive material protecting the surface of the pads 150 against oxidation and promoting its solderability with a solder (not shown). For instance, the surface finish layer 118 may be a layer of ENEPIG (Electroless Nickel Electroless Palladium Immersion Gold) which may have an intermediate layer comprising palladium.

Metal ions and/or metal particles, which may unintentionally tend to accumulate at main surface 110, may be of a metal forming a constituent of the seed layer 114 (for instance palladium) and/or of the surface finish layer 118 (for instance gold). In order to suppress such undesired phenomena, the main surface 110 of the exposed electrically insulating layer structure 106 may be configured to inhibit attraction and attachment of palladium ions and/or particles and/or of gold ions and/or particles on said main surface 110. This may be achieved by taking one or more measures described below.

Moreover, a patterned electrically insulating solder resist constitutes a protection structure 130 and is formed on part of the exposed main surface 110 of the uppermost electrically insulating layer structure 106. An opening in the patterned protection structure 130 may have a larger lateral extension than a lateral extension of any of the pads 150 and even of both pads 150 together. The surface portions of the component carrier 100 remaining covered with solder resist-type protection structure 130 may be protected against oxidation or corrosion, in particular surface portions containing copper (not shown). Said protection structure 130 constitutes an outermost insulating protection layer of the stack 102 in form of solder resist. Alternatively, said protection structure 130 may be a mold compound molded around sub-portions 122, 124 of electrically conductive layer structure 104 (not shown).

During manufacturing the component carrier 100, in particular in view of a seed process of forming seed layer 114 (for example comprising palladium) for pads 150 and/or in view of the process of forming the surface finish layer 118 (for instance comprising gold), there is conventionally a risk of metallic particles, metallic ions, etc. depositing or accumulating on main surface 110. This may reduce electric reliability of component carrier 100 when being manufactured conventionally, because of the formation of erroneous electric connections (for instance by unintentionally short-circuiting pads 150). Furthermore, this may make it conventionally impossible to realize pads 150 with very small horizontal dimensions and with very small horizontal mutual distance when excellent electric reliability is desired.

In order to overcome such conventional shortcomings with the component carrier 100 of Figure 1 according to an exemplary embodiment of the invention, the main surface 110 of the partially exposed electrically insulating layer structure 106 is configured or functionalized to inhibit attraction and attachment of metal ions and/or metal particles on said main surface 110. Generally speaking, said main surface 110 may be functionalized or configured to inhibit said attraction and attachment by depleting said main surface 110 of electric charge carriers, preferably by providing said main surface 110 free of electric charge carriers. Without wishing to be bound the specific theory, it is presently believed that charge carriers on main surface 110 are conventionally a cause for the undesired attachment and attraction of metallic particles there.

One measure for achieving said configuration or functionalization is to inhibit said undesired metallic attraction and attachment on main surface 110 by providing the partially exposed electrically insulating layer structure 106 of a low Df material. For instance, said dielectric material may be selected to have a Df value of less than 0.018, for example in a range from 0.002 to 0.010. For instance, a resin material of electrically insulating layer structure 106 may be selected accordingly. Descriptively speaking, a low Df material of partially exposed electrically insulating layer structure 106 may suppress accumulation of electric charges at main surface 110, which may have a positive impact on the suppression of the formation of metallic particles thereon. In particular, it may be advantageous and sufficient to provide the partially exposed electrically insulating layer structure 106 of a material having a Df value at least 10%, for instance at least 20%, below a Df value of an interior electrically insulating layer structure 108 below said main surface 110. Thus, the outermost electrically insulating layer structure 106 may be functionalized for suppressing metallic particle accumulation at main surface 110, whereas a simple and cheap interior electrically insulating layer structure 108 may be acceptable.

Now referring to a detail 156 of Figure 1, another measure for hindering attraction and attachment of metal ions and/or metal particles on said main surface 110 is the inclusion of a high content of filler particles 112 in the partially exposed electrically insulating layer structure 106. For instance, such filler particles 112 may comprise glass or ceramic particles, for instance spherical particles or beads. Such filler particles 112 may be used for fine-tuning the characteristics of the electrically insulating layer structure 106, for instance for enhancing its thermal conductivity and/or mechanical stability. However, the present inventors have found that the amount of filler particles 112, in particular a sufficiently large amount thereof, may also contribute to the suppression of accumulation of metallic particles at main surface 110. More specifically, the exposed electrically insulating layer structure 106 may be provided with a content of filler particles 112 of at least 70 volume percent in relation to the entire volume of said electrically insulating layer structure 106. Such filler particles 112, in particular when made of glass, may also suppress charge accumulation at main surface 110, since said filler particles 112 themselves are not prone to carry charge carriers. In order to obtain a pronounced positive effect from the filler particles 112 (in particular made of glass), said main surface 110 of said exposed electrically insulating layer structure 106 may be defined by a ratio of a partial filler surface area A1 divided by a partial resin surface area A2 of at least 30%, preferably at least 60%, see detail 156.

Yet another measure for inhibiting metallic particle accumulation at main surface 110 is a corresponding adaptation of the surface topography thereof. In particular, said main surface 110 may be configured to inhibit said attraction and attachment by providing said main surface 110 with a low roughness Rz, in particular with a roughness Rz of less than 1000 nm. Apparently, a sufficiently smooth main surface 110 in terms of roughness Rz may have a positive impact on the suppression of metallic particle accumulation thereon.

A physical and/or chemical surface treatment or surface activation of main surface 110 may also enhance its ability of hindering said attraction and attachment of metallic particles. In particular, this may be achieved by rendering said main surface 110 hydrophobic. The capability of electrically insulating layer structure 106 with its main surface 110 to inhibit said attraction and attachment may also be further enhanced by being treated to generate low van der Waals forces, because also this measure tends to keep away electric charge carriers from main surface 110.

Thanks to its described functionalization or configuration, the exposed main surface 110 of the electrically insulating layer structure 106 is configured to inhibit said attraction and attachment on said main surface 110 more than on an opposing other main surface 132 of said electrically insulating layer structure 106. This difference on the opposing main surfaces 110, 132 can be considered as fingerprint of the mentioned functionalization or configuration.

During a manufacturing process, it may be possible to remove, in particular by stripping, metal ions and/or metal particles from the exposed main surface 110. Also this may lead to a reduction of metal at undesired surface portions of main surface 110. However, in view of the above mentioned measures for hindering attraction and attachment of metallic particles on main surface 110, such a stripping process (in particular palladium stripping process) may be a very simple process. In yet another embodiment, palladium stripping may also be omitted. This may reduce the manufacturing effort of component carrier 100.

Still referring to Figure 1, said electrically conductive layer structure 104 comprises sub-portions 122, 124 arranged side-by-side. A portion of said main surface 110 between different sub-portions 122, 124 defines a first area 126 with residues (not visible in Figure 1) of metallic material of the surface finish layer 118. A further portion of said main surface 110 between different sub-portions 122, 124 defines a second area 128 free of metallic material. Said second area 128 is arranged between two of said first areas 126 and may have a larger planar extension than said first areas 126. Advantageously and thanks to the measures for inhibiting attraction and attachment of metallic particles on main surface 110, the first area 126 and the second area 128 are configured so that an electric conduction between the two sub-portions 122, 124 is disabled. As a result, pads 150 of the two sub-portions 122, 124 may remain electrically decoupled from each other, so that a component carrier 100 with high electric reliability may be obtained.

**Figure 2** illustrates a cross-sectional view of a component carrier 100 according to another exemplary embodiment of the invention. Reference is also made to the corresponding elements of Figure 1.

The metal depletion between horizontally adjacent pads 150 (in particular in second area 128) makes it possible to provide small pads 150 with small mutual distance in between adjacent pads 150. As shown in Figure 2, a distance d between said pads 150 may be lower than 130 µm, preferably in a range from 30 µm to 70 µm. A diameter D of said pads 150 may be lower than 300 µm, preferably lower than 100 µm, see again Figure 2. Thus, exemplary embodiments of the invention may allow to manufacture component carriers 100 in a compact way with very small dimensions of metallic structures.

According to Figure 2, the two outermost laminated electrically insulating layer structures 106, 108 are both shown in detail. In this embodiment, outer electrically insulating layer structure 106 can be made of a dielectric material having a lower Df value than directly connected inner electrically insulating layer structure 108. For example, electrically insulating layer structure 108 may be made of standard ABF material, whereas electrically insulating layer structure 106 may be made of low Df ABF material (for instance ABF material of the GL series, such as GL107). This combines the low manufacturing effort of electrically insulating layer structure 108 with the enhanced ability of electrically insulating layer structure 106 to inhibit attraction and attachment of metal ions and/or metal particles on said main surface 110. Thus, the exposed material of the electrically insulating layer structure 106 defining main surface 110 is different from material of the adjacent other electrically insulating layer structure 108. Consequently, redistribution structure 120 is embedded partially in low Df electrically insulating layer structure 106 and partially in electrically insulating layer structure 108 made of a different material with different main surface interaction characteristics. Moreover, the main surface 110 of the electrically insulating layer structure 106 is configured to inhibit said attraction and attachment on said main surface 110 more than on opposing other main surface 132 of said electrically insulating layer structure 106 and more than on any main surface 134 of the other electrically insulating layer structure 108.

With the configuration according to Figure 2, a small pad size (D) and a small pad space (d) on the back side of the component carrier 100 may be achieved. In particular, this may be made possible by the use of a low Df dielectric material (for example low Df ABF) on an EP layer and reduce the effort involved by the palladium strip.

For example, a mixed low Df ABF material may be used, for instance having a Df value smaller than 0.0022, in particular in a range from 0.003 to 0.0022 on the EP layer. By exemplary embodiments, metal-defined pad space (d) can reach 30 µm. Metal-defined pad size (D) can reach 77 µm. Moreover, exemplary embodiments offer the possibility to remove one palladium strip process with big space, for instance a single palladium strip process may be carried out.

A lateral distance, H, between a side wall of protection structure 130 and a sidewall of surface finish layer 118 on pad 150 may be less than 80 µm, for example 60 µm. A vertical height, h, of pad 150 may be less than 30 µm, for example 15 µm. A vertical height, b, of surface finish layer 118 may be less than 15 µm, for example 7 µm. A vertical distance, L, between a top surface of protection structure 130 and a top surface of surface finish layer 118 may be less than 30 µm, for example 21 µm.

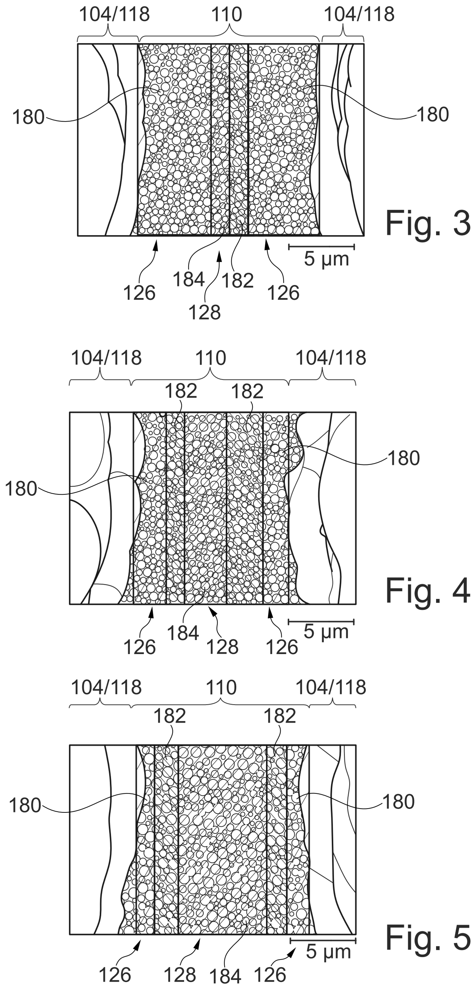

Figures 3 to 8 illustrate plan views of component carriers 100 according to exemplary embodiments of the invention. The amount of gold particles is an indicator of the application performance on dielectric resin (for example ABF) material. The gold distributions shown in Figure 3 to Figure 8 are in accordance with the ions deposition mechanisms according to Figure 1, Figure 10 and Figure 11. Gold inspection according to Figure 3 to Figure 8 shows three regions which have different gold (or more generally metal, since other seed layer and/or surface finish materials are possible) density: A gold or metal rich region 180 in which the metal or gold particles density is biggest, a gold or metal middle region 182 in which the metal or gold particles density is smaller and a gold or metal minimum region 184 in which metal or gold particles exist only sporadic, may be distinguished.

Referring to **Figure 3****,** low Df ABF GL107 on an EP layer (which may be a layer below solder resist) has been used with a 30 µm space and a solder resist palladium strip conveyor speed of 2.0m/min (POR and GXT31).

Referring to **Figure 4****,** low Df ABF GL107 on an EP layer has been used with a 30 µm space and a solder resist palladium strip conveyor speed of 2.0m/min (POR and GL107).

Referring to **Figure 5****,** low Df ABF GL107 on an EP layer has been used with a 30 µm space and a solder resist palladium strip conveyor speed of 1.0m/min (POR and GXT31).

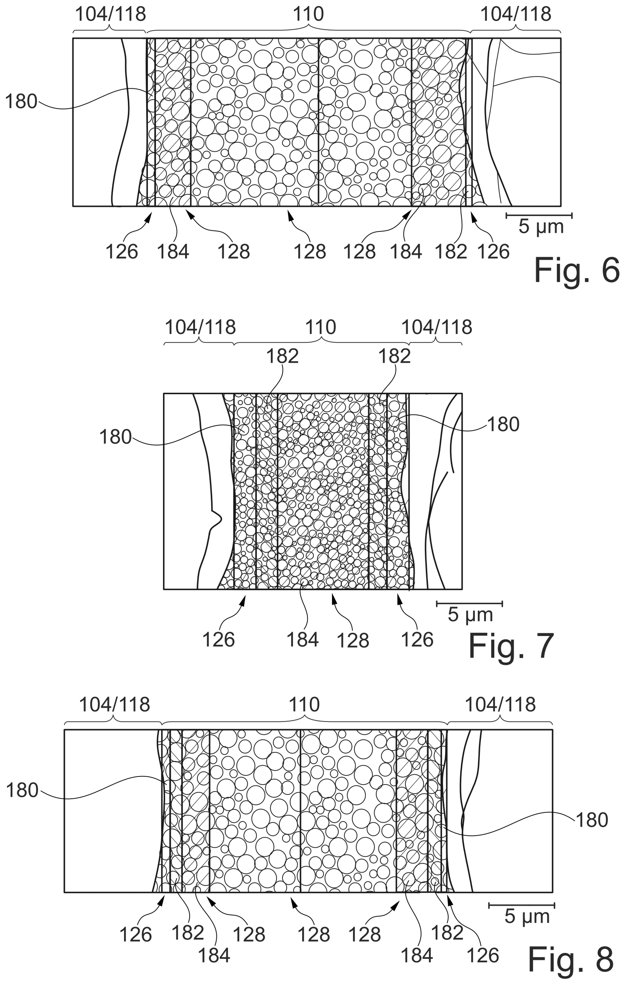

Referring to **Figure 6****,** low Df ABF GL107 on an EP layer has been used with a 40 µm space and a solder resist palladium strip conveyor speed of 1.0m/min (POR and GXT31).

Referring to **Figure 7****,** low Df ABF GL107 on an EP layer has been used with a 30 µm space and a solder resist palladium strip conveyor speed of 1.0m/min (POR and GL107).

Referring to **Figure 8****,** low Df ABF GL107 on an EP layer has been used with a 40 µm space and a solder resist palladium strip conveyor speed of 1.0m/min (POR and GL107).

A conclusion of the shown experiments is that a low Df ABF GL107 with a Df value smaller than 0.003 shows a proper capability with all metal-defined pad spaces.

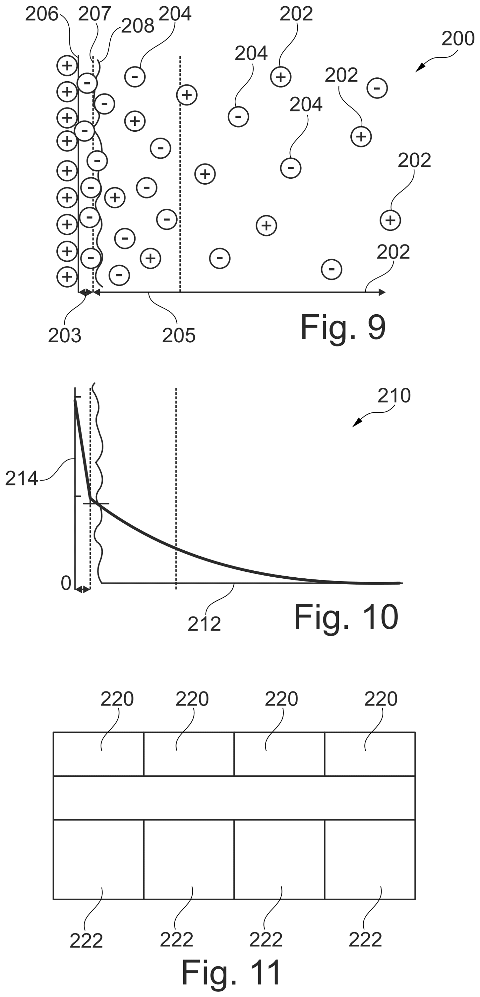

Figures 9 and 10 show diagrams 200, 210 indicating metal presence on a surface of component carriers 100 according to exemplary embodiments of the invention.

Referring to diagram 200 of **Figure 9****,** an abscissa 202 indicates a physical dimension. Positive charge carrier 202 and negative charge carriers 204 are plotted. Reference sign 206 indicates a surface, reference sign 207 a stern plane and reference sign 208 a shear plane. A stern layer 203 and a diffuse layer 205 are shown as well.

Referring to diagram 210 of **Figure 10****,** an abscissa 212 indicates a distance or physical dimension, whereas an ordinate 114 indicates a potential.

Making reference to the Figures 9, 10 and 1, it will be explained in the following why a low Df dielectric material of electrically insulating layer structure 106 has an advantageous capability for a metal-defined pad design. In this context, a metal-defined design of a pad 150 describes a configuration in which air is laterally around a pad 150, see reference sign 162 in Figure 1. This is in contrast to a configuration in which a solder resist-type protection structure 130 laterally overlaps with pads 150 so as to cover at least part of its sidewall (not shown). In a process of manufacturing a metal-defined pad 150, a palladium seed used for forming pads 150 may unintentionally act also as seed for a surface finish 118. This may lead to accumulation of metallic particles on exposed portions of a main surface 110 of an outer electrically insulating layer structure 106, which can be suppressed by using a low Df dielectric for outer electrically insulating layer structure 106.

Ions have a defined size, and the center of an ion can only approach a surface within its hydrated radius. Furthermore, ions are attached, albeit temporarily, to a surface by an electrostatic force strong enough to overcome thermal agitation. In view of these configurations, the following phenomena may lead toward the improvements of exemplary embodiments in terms of hindering metallic particle accumulation on main surface 110: A low Df resin (such as ABF) can store more ions than a dielectric with a higher Df value, so that a low Df resin may act against a diffusion or migration of electric charge to the main surface 110. Consequently, metallic (in particular palladium) absorption by surface ions may be smaller, after a process of forming surface finish layer 118 (in particular ENEPIG). As a result, also gold particle deposition on main surface 110 may be smaller.

Normally, electric charge of a dielectric material of electrically insulating layer structure 106 might move to main surface 110 based on an electromag-netokinetic phenomenon. Finally, such an electric charge may generate surface electric charge.

However, Df is one of main properties of dielectric material which can impact the dielectric loss, as it presents the property of an ability for hindering electric charge moving to a surface or storing the electric charge (see Figure 9). Electric charge on main surface 110 may accumulate at an area like the area between metal-defined pads 150.

Generally, Pd+ of electroless plating can enhance the adhesion between dielectric material of electrically insulating layer structure 106 and a seed layer, since palladium ions may act as a catalyst in an electroless plating process. Thus, this may promote the deposition of metals like nickel or copper or gold onto the dielectric surface or other metal surface. This catalytic activity may help in forming a strong bond between the seed layer and the dielectric layer, so palladium ions can form strong chemical bonds with both the seed layer and the dielectric material. This bonding improves the overall adhesion and stability of the layers. Moreover, the presence of palladium ions can activate the surface of the dielectric layer, making it more receptive to the deposition of the seed layer. This activation process helps in creating a uniform and adherent metal layer. Pd⁺ may be absorbed by electric charge of main surface 110 of electrically insulating layer structure 106. If this happens, there may be a need to remove the remaining Pd⁺ afterward.

As during an ENEPIG process, Ní⁺ and/or Au⁺ reacting with Pd⁺ may cause overplating of gold on a solder resist layer, a palladium strip may become necessary or desired. However, it may be also difficult to remove the Pd⁺ in the presence of fine patterns.

Advantageously, a low Df dielectric of electrically insulating layer structure 106 may store more ions to prevent them from diffusing. Based on the considerations above, it may be concluded that using dielectric material with low Df for outer electrically insulating layer structure 106 can inhibit electric charge from moving to the main surface 110 of the electrically insulating layer structure 106, so that a better storage of electric charge in the material may become possible.

**Figure 11** illustrates a manufacturing architecture of manufacturing a component carrier 100 according to an exemplary embodiment of the invention.

Figure 11 illustrates a further option to inhibit attraction and attachment of metal ions and/or metal particles on said main surface 110. According to this option, which may be combined with any of the aforementioned options, in may be possible to reduce the solder resist palladium strip conveyor speed. Figure 11 shows a plurality of legs 220 (leg 1 to leg 4 in the shown example). Furthermore, different palladium strip conveyor speeds are indicated with reference sign 222 (1 m/ml for leg 1, 1.3 m/ml for leg 2, 1.6 m/ml for leg 3, 2.0 m/ml for leg 4).

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A component carrier (100), which comprises:
a stack (102) which comprises at least one electrically conductive layer structure (104) and a plurality of electrically insulating layer structures (106, 108), at least part of said at least one electrically conductive layer structure (104) being provided on and/or in a main surface (110) of one of said plurality of electrically insulating layer structures (106, 108); and
a surface finish layer (118) at least partially covering an exposed surface of said at least one electrically conductive layer structure (104);
wherein the main surface (110) of the one of said plurality of electrically insulating layer structures (106, 108) is configured to inhibit attraction and attachment of metal ions and/or metal particles on said main surface (110).

2. The component carrier (100) according to claim 1, wherein said main surface (110) is configured to inhibit said attraction and attachment by providing said one of said plurality of electrically insulating layer structures (106, 108) of a low Df material.

3. The component carrier (100) according to claim 1 or 2, wherein said main surface (110) is configured to inhibit said attraction and attachment by providing said one of said plurality of electrically insulating layer structures (106, 108) with high content of filler particles (112), and/or wherein said main surface (110) is configured to inhibit said attraction and attachment by providing said one of said plurality of electrically insulating layer structures (106, 108) with a content of filler particles (112) of at least 70 volume percent in relation to an entire volume of said one of said plurality of electrically insulating layer structures (106, 108), and/or wherein the one of said plurality of electrically insulating layer structures (106, 108) comprises filler particles (112) at the main surface (110) which are configured to promote the inhibition of said attraction and attachment.

4. The component carrier (100) according to any of claims 1 to 3, wherein said main surface (110) is configured to inhibit said attraction and attachment by providing said main surface (110) with a low roughness Rz, and/or wherein said main surface (110) is configured to inhibit said attraction and attachment by providing said main surface (110) with a roughness Rz of less than 1000 nm.

5. The component carrier (100) according to any of claims 1 to 4, wherein said main surface (110) is configured to inhibit said attraction and attachment by depleting said main surface (110) of electric charge carriers (202, 204), in particular by providing said main surface (110) free of electric charge carriers (202, 204).

6. The component carrier (100) according to any of claims 1 to 5, wherein the metal ions and/or metal particles are of a metal forming at least one constituent of the at least one electrically conductive layer structure (104), in particular a seed layer (114) of the at least one electrically conductive layer structure (104), and/or of the surface finish layer (118), wherein in particular the at least one constituent comprises palladium.

7. The component carrier (100) according to any of claims 1 to 6, wherein exposed material of the one of said plurality of electrically insulating layer structures (106, 108) defining at least part of said main surface (110) is different from material of another one of said electrically insulating layer structures (106, 108).

8. The component carrier (100) according to any of claims 1 to 7, wherein the one of said electrically insulating layer structures (106, 108) defining the main surface (110) is part of a redistribution structure (120) together with said at least one electrically conductive layer structure (104), wherein in particular said redistribution structure (120) comprises another of said electrically insulating layer structures (106, 108) with a different material and/or with different main surface interaction characteristics compared with said one of said plurality of the electrically insulating layer structures (106, 108) defining the main surface (110).

9. The component carrier (100) according to any of claims 1 to 8, wherein the surface finish layer (118) is in contact with the main surface (110).

10. The component carrier (100) according to any of claims 1 to 9, wherein said at least one electrically conductive layer structure (104) comprises at least two sub-portions (122, 124) arranged side-by-side, wherein a portion of said main surface (110) between different sub-portions (122, 124) defines a first area (126) with metallic material of the surface finish layer (118), and/or wherein said at least one electrically conductive layer structure (104) comprises at least two sub-portions (122, 124) arranged side-by-side, wherein a portion of said main surface (110) between different sub-portions (122, 124) defines a second area (128) free of metallic material.

11. The component carrier (100) according to claim 10, wherein said second area (128) is arranged between two of said first areas (126).

12. The component carrier (100) according to claim 10 or 11, wherein said second area (128) has a larger planar extension than said first area (126).

13. The component carrier (100) according to any of claims 10 to 12, wherein each of said first area (126) and said second area (128) is covered by a protection structure (130).

14. The component carrier (100) according to any of claims 10 to 13, wherein said at least two sub-portions (122, 124) comprise pads (150), wherein in particular a distance (d) between said pads (150) is lower than 130 µm, in particular is in a range from 30 µm to 70 µm, and/or wherein in particular a diameter (D) of said pads (150) is lower than 300 µm, in particular is lower than 100 µm.

15. A method of manufacturing a component carrier (100), wherein the method comprises:
providing a stack (102) which comprises at least one electrically conductive layer structure (104) and a plurality of electrically insulating layer structures (106, 108), at least part of said at least one electrically conductive layer structure (104) being provided on and/or in a main surface (110) of one of said plurality of electrically insulating layer structures (106, 108);
at least partially covering an exposed surface of said at least one electrically conductive layer structure (104) by a surface finish layer (118); and
configuring the main surface (110) of the one of said plurality of electrically insulating layer structures (106, 108) to inhibit attraction and attachment of metal ions and/or metal particles on said main surface (110).
